# EUROPÄISCHE PATENTSCHRIFT

(11) **EP 2 129 553 B1**
(45) Veröffentlichungstag und Bekanntmachung des Hinweises auf die Patenterteilung: **02.07.2014**
(21) Anmeldenummer: 08701354.6
(22) Anmeldetag: 09.01.2008
(51) Int. Cl.: B60R 21/01, B60R 19/48, B60R 16/023, F16B 19/10, F16B 5/02, H05K 5/00, F16B 13/12, F16B 19/00, F16B 19/02, H05K 5/02

(54) **UNFALLSENSOR**
ACCIDENT SENSOR
CAPTEUR D'ACCIDENT

(30) Priorität: 28.02.2007 DE 102007009692
(43) Veröffentlichungstag der Anmeldung: 09.12.2009
(73) Patentinhaber: Robert Bosch GmbH, 70442 Stuttgart (DE)
(72) Erfinder: BRANDT, Tobby, 71034 Boeblingen (DE); OHL, Christian, 72793 Pfullingen (DE); ADAM, Boris, 71126 Gaeufelden (DE); SCHUERER, Martin, 72631 Aichtal (DE)
(86) Internationale Anmeldenummer: PCT/EP2008/050190
(87) Internationale Veröffentlichungsnummer: WO 2008/104413

(56) Entgegenhaltungen:
- EP-A- 1 445 497
- EP-A- 1 473 470
- WO-A-2006/052015
- WO-A-2007/054397
- DE-A1- 10 259 527
- DE-A1- 19 618 632
- US-A- 5 846 040
- WOLGANG BEITZ, KARL-HEINZ KÜTTNER: "Dubbel, Taschenbuch für den Maschinenbau, 17 Auflage" 1990, SPRINGER-VERLAG , BERLIN, HEIDELBERG , XP002475611 Seite G34; Abbildungen 48-50

## Beschreibung

### Stand der Technik

Die Erfindung betrifft einen Unfallsensor nach der Gattung des unabhängigen Patentanspruchs.

Aus DE 199 23 985 A1 ist eine Sensorbaugruppe bekannt, bei der das Gehäuse eines Luftdrucksensors, der zur Seitenaufprallsensierung verwendet wird, über Befestigungsmittel, beispielsweise Schrauben, an einer Wand im Fahrzeug befestigt wird. Auch DE 191 06 311 A1 lehrt, dass ein Luftdrucksensor in der Wand an einer Trennwand zwischen Nassraum und Trockenraum in der Tür eingebaut wird. Dabei ragt ein Druckkanal in den Nassraum hinein, während der Luftdrucksensor sich selbst im Trockenraum befindet. Es ist ein Dichtkissen vorgesehen, das das Gehäuseinnere gegen den Drucksensor abdichtet und auch das Gehäuse gegen die Trennwand.

Aus DE 10 259 527 A1 ist ein Hallsensor bekannt, der in einem Bodenstück eines Stehbolzens befestigt ist. Auf das freie Endstück des Stehbolzens ist eine hutförmige Hülse aufgeschraubt. Die hutförmige Hülse greift, unter Zwischenfügung eines Gleitlagers in eine Bohrung eines Längsträgers eines Fahrzeugs ein.

### Offenbarung der Erfindung

Der erfindungsgemäße Unfallsensor mit den Merkmalen des unabhängigen Patentanspruchs hat demgegenüber den Vorteil, dass der Unfallsensor wenigstens eine Bohrung aufweist, die einen Bolzen in einer elastisch ausgebildeten Hülse als dem Befestigungsmittel aufweist. Der Bolzen ist mit der Hülse so gestaltet, dass der Unfallsensor mit dem Bolzen in der Hülse in der Wand durch eine Klemmung befestigt wird. Dies ermöglicht eine einfache Montage des Unfallsensors an der Wand im Fahrzeug, beispielsweise einem Türblech, wobei keine Werkzeuge für die Montage erforderlich sind. Insbesondere ermöglicht diese erfindungsgemäße Befestigungsmethode eine Einhandmontage, da die andere

Hand nicht notwendig ist, um ein Werkzeug zu halten. Der Bolzen mit der Hülse dient gleichzeitig als Abdichtung des Loches in der Wand, um den Trockenraum, in dem sich der Unfallsensor befindet, vom Nassraum effizient abzudichten. Diese einfache Methode erlaubt es, auf Buchsen im Sensor zu verzichten, insbesondere mechanische Gegenlager, beispielsweise bei einer Anschraubtechnik, wie im Stand der Technik bekannt. Durch die elastische Ausformung der Hülse kann die Befestigungskraft und die mechanische Härte bei Anbindung an das Türblech und damit auch das Resonanzverhalten beeinflusst bzw. ausgelegt werden. Insbesondere können dabei hochfrequente mechanische Resonanzen effizient gedämpft werden. Der erfindungsgemäße Unfallsensor sorgt durch seine Ausbildung für eine Kosteneinsparung in erheblichem Maße.

Der Unfallsensor ist erfindungsgemäß entweder ein Beschleunigungs-, Körperschall- oder Luftdrucksensor. Es ist auch möglich, eine Umfeldsensorik mit dem erfindungsgemäßen Befestigungskonzept einzubauen. Zu solchen Umfeldsensoren gehören Video-, Radar-, Ultraschall- oder Lidarsensoren.

Die Wand ist vorzugsweise ein Türblech, das in der Fahrzeugtür den Nassraum vom Trockenraum trennt. Eine Fahrzeugtür weist üblicherweise einen Nassraum auf und zwar auf der Seite, an der das Fenster des Fahrzeugs herunterbewegt werden kann.

Der Bolzen ist üblicherweise metallisch gebildet, kann aber auch aus Kunststoff hergestellt werden. Der Bolzen sorgt durch seine Formung für die Klemmung, die dann durch die Hülse zu einer Verdickung führt, sodass, wenn der Bolzen mit der Hülse durch die Bohrung in der Wand hindurchgeführt wird, dies zur Befestigung des Unfallsensors führt. Die Hülse ist elastisch ausgeformt, sodass sie typischerweise aus einem gummiartigen oder anderen weichen Kunststoff, beispielsweise Silikon, gebildet ist. Der Bolzen kann im Anlieferzustand in der elastischen Hülle vormontiert sein. Abhängig von der detaillierten Auslegung erfolgt die Befestigung beispielsweise, indem zunächst die Hülse im Urzustand, beispielsweise mit vormontiertem Bolzen durch das Befestigungsloch geschoben wird und danach der Bolzen in die elastische Hülse gedrückt wird, bis zu einer Endposition, was zu einer Verdickung der Hülse und damit zu einer Verklemmung des Sensors führt. Die Klemmung bedingt, dass die Hülse mit Bolzen und damit der Sensor selbst, wenn sie durch die Bohrung in der Wand hindurchgeschoben wurde, nicht mehr einfach herausfallen, sondern nur mit hoher Kraft herausgerissen werden kann.

Vorteilhafte Weiterbildungen gehen aus den abhängigen Ansprüchen hervor.

Besonders vorteilhaft ist, dass der Bolzen so gestaltet ist, dass der Bolzen beim Hineinschieben in die Hülse eine Aufweitung und/oder eine Verspreizung der Hülse verursacht, wobei die Aufweitung und/oder die Verspreizung letztlich die Klemmung bewirkt. Das heißt, dass der Bolzen alleine durch die Bohrung in der Wand hindurchführbar ist, aber mit der Hülse, die elastisch ist, dies nur mit Kraft geschehen kann, um die Hülse beim Hindurchführen zusammenzudrücken, wobei sie sich nach dem Durchführen wieder entspannt und dadurch einen Widerstand gegen ein Zurückziehen bildet. Dieser Widerstand kann durch eine Aufweitung, also eine Verdickung, geschehen oder durch eine Verspreizung, beispielsweise, indem der Bolzen durch die Hülse durchbricht und diese dadurch an der Spitze aufweitet.

Weiterhin ist es vorteilhaft, dass der Bolzen wenigstens einen ersten Abschnitt für die Klemmung und einen nachfolgenden zweiten Abschnitt aufweist, der dünner als der erste Abschnitt ist. Damit wird in einfacher Art und Weise erreicht, dass ein Abschnitt die Hülse zu einer Verdickung oder der Aufspreizung führt und der nachfolgende Abschnitt dann wieder nicht. Damit ist die Handhabbarkeit des erfindungsgemäßen Befestigungskonzepts erheblich erleichtert.

Der Bolzen kann vorteilhafterweise auch einen dritten Abschnitt aufweisen, wobei dieser dritte Abschnitt wenigstens einen Widerhaken aufweist. Dieser Widerhaken bewirkt, dass der Bolzen aus der Hülse nicht mehr leicht herausschiebbar ist. Auch andere geometrische Ausformungen des Bolzens, die nicht einem Widerhaken entsprechen, aber dennoch einen Widerstand gegen das Herausziehen bilden, sind vorliegend möglich. Dieser dritte Abschnitt kann mit dem ersten Abschnitt weitgehend identisch sein, da die Verdickung auch gleichzeitig als Widerhaken ausgebildet sein kann.

Vorteilhafterweise dehnt der Bolzen die Hülse der Länge nach, wenn er in die Hülse hineingeschoben wird. Dies führt zu einer guten Abdichtung der Hülse am Türblech, denn beim Einschieben des Bolzens in die Hülse dehnt sich die Hülse der Länge nach. Wenn dann genug Spannung aufgebaut ist, rutscht die Engstelle der Hülse über den Bolzen, der Durchmesser der Hülse vergrößert sich und gleichzeitig nimmt die Kraft, die die Hülse dehnt, ab, sodass der Pfropfen des Bolzens an das zu dichtende Loch hingezogen und angepresst wird. Bei adäquater Auslegung wird dadurch die Dichtwirkung des Bolzens sichergestellt bzw. verbessert.

Vorteilhafterweise weist die Hülse wenigstens eine Rippe oder wenigstens eine Rastnase auf, die ein Zurückrutschen der Hülse nach dem Durchführen durch die Türwand verhindert.

Der Bolzen kann, wie oben angedeutet so gestaltet sein, dass er beim Hineinschieben so gestaltet sein, dass er die Hülse durchbricht, sodass die Hülse sich spreizt oder den Bolzen hintergreift und so auch ein Zurückschieben des Bolzens aus der Hülse heraus verhindert. Verspreizung führt zu einer effektiven Klemmwirkung.

Der Unfallsensor ist derart gestaltet, dass der Unfallsensor einen Stecker für einen Anschluss von Kabeln erst freigibt, wenn der Bolzen mit der Hülse in eine Endposition zur Befestigung des Unfallsensors geschoben ist. Diese Endposition bedeutet, dass der Bolzen bzw. die Hülse auf dem Unfallsensor aufliegen, sodass die Klemmwirkung optimal den Unfallsensor an der Wand hält. Liegt der Bolzen mit der Hülse noch nicht auf dem Unfallsensor auf, dann versperrt der Bolzen mit der Hülse den Zugang zum Anbringen der Kabel an den Unfallsensor. Dies ermöglicht eine zusätzliche Sicherung, sodass der Unfallsensor sicher durch den Monteur eingebaut wird.

Ausführungsbeispiele sind in der Zeichnung dargestellt und werden in der nachfolgenden Beschreibung näher erläutert.

Es zeigen:
- Figur 1: eine Einbauposition des erfindungsgemäßen Unfallsensors,
- Figur 2a, b und c: die Einbauposition bzw. wie der Bolzen in die Hülse eingeführt wird,
- Figur 3a bis c: drei Beispiele für eine Ausprägung des Bolzen-Hülsen-Systems,
- Figur 4: ein weiteres Beispiel, wie ein Bolzen in die Hülse eingeführt wird und
- Figur 5a bis c: ein Aufspreizen der Hülse bei der Befestigung des Unfallsensors.

Erfindungsgemäß wird vorgeschlagen, einen Unfallsensor mit einem Bolzen und einer Hülse, die durch eine Bohrung im Unfallsensor geführt werden, an einer Wand im Fahrzeug zu befestigen, indem Bolzen mit Hülse durch ein Loch in der Wand hindurchgeführt werden und durch Klemmwirkung den Unfallsensor halten. Dies kann durch Stifte oder Schraubungen ergänzt werden, um die Einbaulage genauer zu definieren. Die genauere Einbaulage-kann auch durch eine Mehrzahl von Bolzen mit Hülsen geschickt definiert werden. Dabei ist es möglich, dass der Bolzen vor der Befestigung in der Wand bereits in der Hülse ist oder erst für die Befestigung in der Wand, nachdem die Hülse bereits durch das Loch in der Wand geführt wurde, in die Hülse eingeführt wird und damit die Klemmwirkung durch eine Verdickung der Hülse hinter dem Loch in der Wand bewirkt.

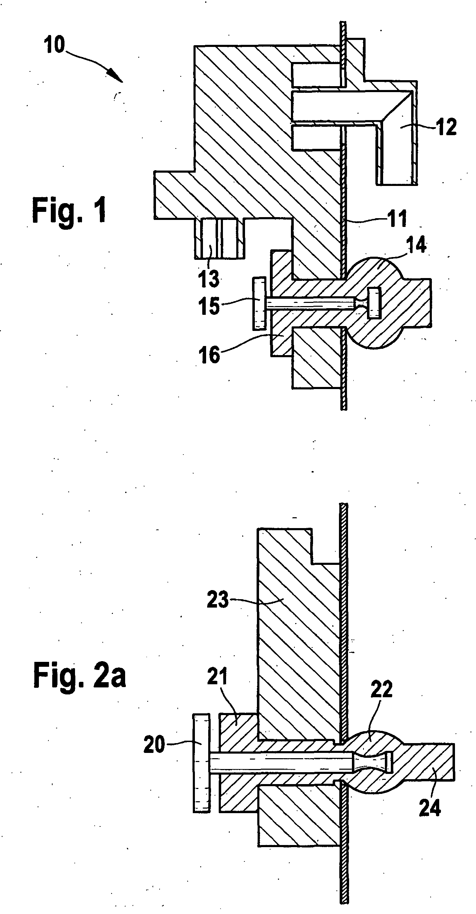

Figur 1 zeigt schematisch, wie ein Luftdrucksensor 10 in einer Fahrzeugtür 11 mittels des erfindungsgemäßen Befestigungskonzepts eingebaut ist. Durch die obere Öffnung in der Wand 11 wird ein Druckkanal 12 des Luftdrucksensors 10 eingeführt, um im Nassraum den Luftdruck messen zu können. Durch eine zweite Öffnung der Wand 11 wird ein Bolzen 15 mit einer elastischen Hülse 16 hindurchgeführt, wobei der Bolzen 15 nach dem Durchführen durch die Öffnung in der Wand eine Verdickung 14 in der Hülse 16 bewirkt und so eine Klemmwirkung verursacht, die den Sensor 10 an der Wand 11 festhält. Im eingebauten Zustand geben der Bolzen 15 mit der Hülse 16 einen Stecker oder eine Buchse 13 am Luftdrucksensor 10 frei, an die signalführende Kabel angeschlossen werden können. Damit wird eine effiziente Sicherung gegen einen Fehleinbau bewirkt, indem der elektrische Anschluss zum Luftdrucksensor 10 nur freigegeben wird, wenn Bolzen 15 mit Hülse 16 korrekt eingebaut sind.

Figur 2a zeigt erneut den eingebauten Zustand des Luftdrucksensors 23 mit der Hülse 24 und dem Bolzen 20, wobei die Hülse 24 eine Verdickung 22 nach der Öffnung in der Wand aufweist. Die Hülse ist hier mit 24 bezeichnet, und die Hülse 24 weist Verdickungen 21 auf, die den Luftdrucksensor 23 hintergreifen und so durch den Anpressdruck durch den Bolzen 20 in befestigtem Zustand den Luftdrucksensor halten. Die Hülse 24 kann dabei entsprechend bezüglich Härte eingestellt werden, um eine entsprechende Kraft aufzunehmen.

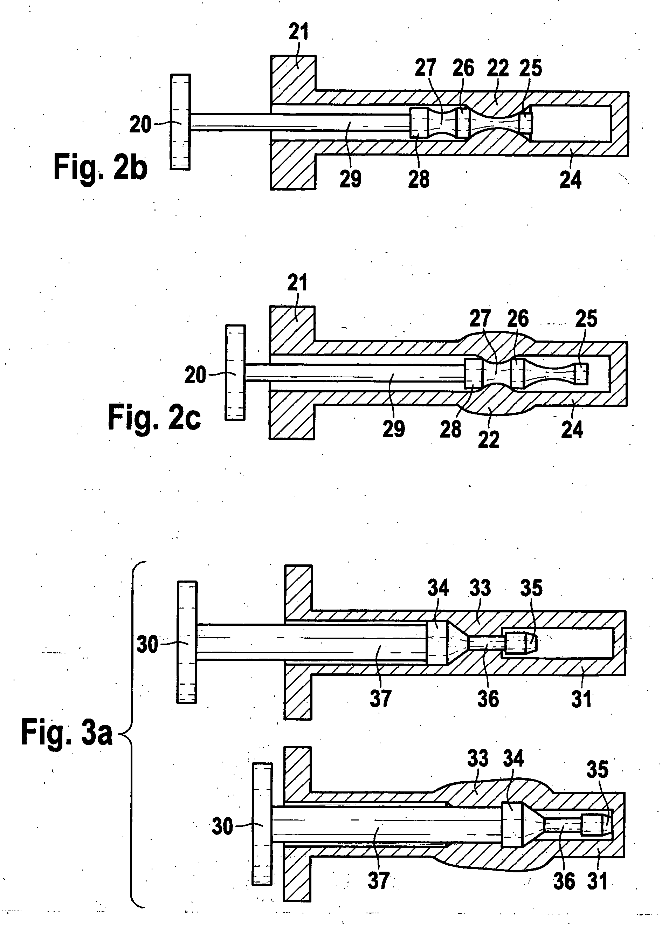

In Figur 2b wird gezeigt, wie der Bolzen 20 in die Hülse 24 zum Teil eingeführt wird. Ein erster Abschnitt 25 ist hierbei durch eine Engstelle 22 hindurchgeführt, wobei auf die Spitze 25 des Bolzens 20 ein sich wieder verdünnender Abschnitt folgt. Danach folgt eine Verdickung 26 im Bolzen, der zur Aufweitung der Engstelle 22 führen wird. Diese Verdickung 26 ist wiederum von einer Verdünnung 27 gefolgt und wiederum von einer Verdickung 28, die ebenfalls dann die Funktion des Widerhakens hat. Danach folgt ein Abschnitt 29 mit gleichbleibender Dicke bis zum Ende.

Figur 2c zeigt nunmehr, wie der Bolzen 20 weitergewandert ist und durch seine Verdickungen 26 und 28 zu einer Aufweitung der Hülse 24 an der Engstelle 22 führt. Gleiche Bezugszeichen bezeichnen hier gleiche Elemente.

Die Figuren 3a bis c zeigen Realisierungsmöglichkeiten für den Einhandmontagebolzen mit integriertem Widerhaken, bestehend aus elastischer Hülse und starrem Arretierbolzen. Figur 3a zeigt im oberen Bild, wie der Bolzen durch die Engstelle 33 hindurchgeführt wird, und zwar mit seiner Spitze 35, die noch zu keiner Aufweitung führt. Die Verdickung 34 mit Widerhaken führt dann im unteren Bild zur Aufweitung der Engstelle 33. Danach folgt wieder ein gleichmäßiger Zylinder 37 bis zum Ende des Bolzens 30. Auch zwischen der Verdickung 34 ist ein vergleichsweise dünner Abschnitt 36 vorgesehen. Auch hier bezeichnen gleiche Elemente gleiche Bezugszeichen.

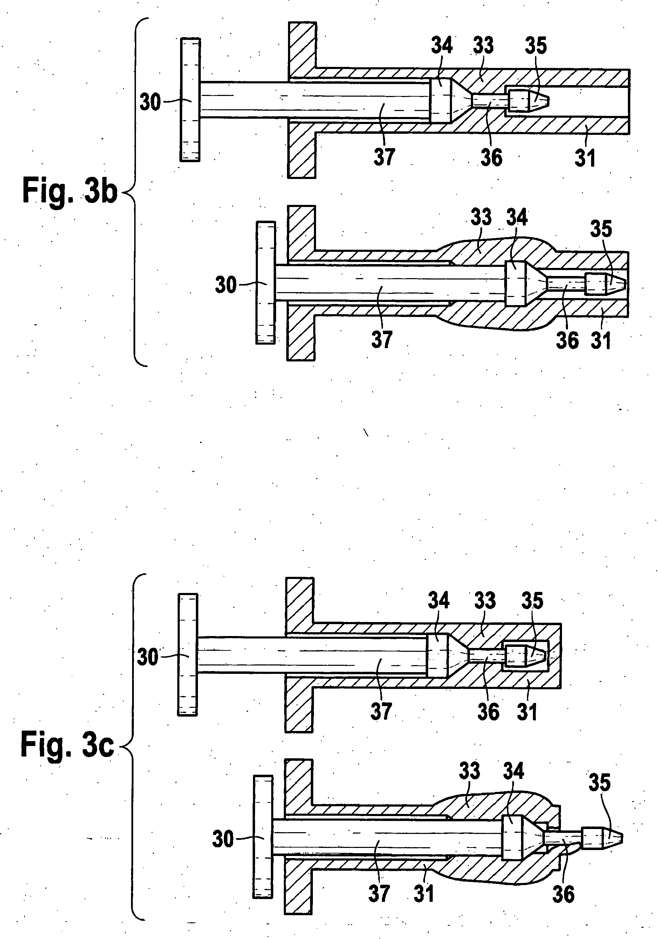

Figur 3b zeigt eine weitere Konfiguration, bei der die Spitze 35 tiefer in die Hülse eindringt. Figur 3c dagegen zeigt einen Durchbruch durch die Hülse 31, wobei durch den Abschnitt 36 die Spitze 35 des Bolzens 30 hintergriffen wird und so ein Zurückschieben des Bolzens effektiv verhindert wird.

Figur 3a zeigt damit eine einfache Ausführung mit Abdeckung des Bolzens. Figur 3b zeigt eine fertigungsoptimierte Lösung für die Hülse und Figur 3c eine Lösung mit zusätzlichem mechanischen Widerstand.

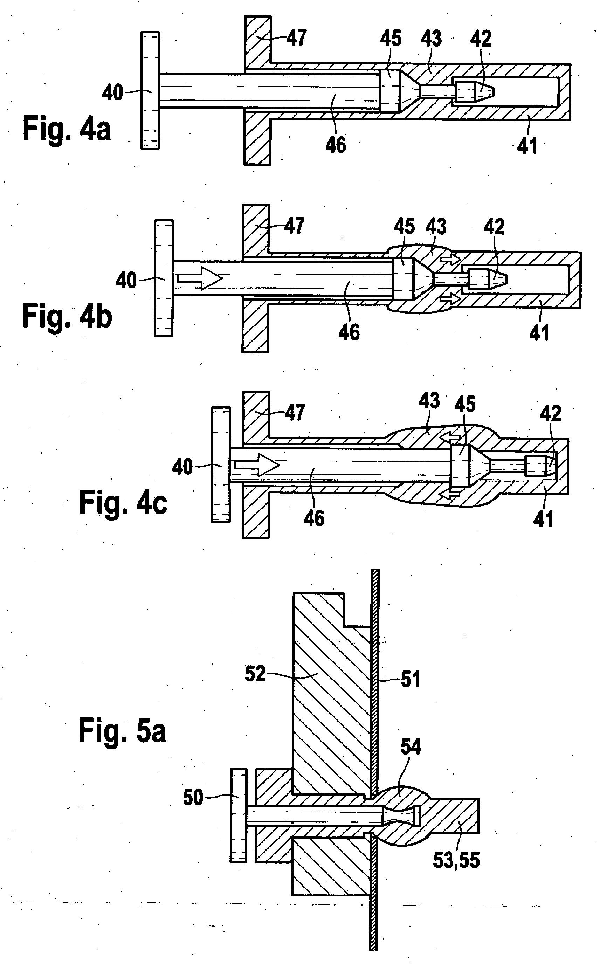

Die Figuren 4a bis c zeigen eine Realisierung der Dichtefunktion des Bolzens. Der Bolzen ist mit dem Bezugszeichen 40 durchgängig bezeichnet, sowie die Hülse mit 41 bezeichnet wird, der Abschnitt, der die Wand hintergreift, mit 47, die Verdickung des Bolzens mit 45, die Engstelle der Hülse mit 43 und die Spitze des Bolzens mit 42. Der Abschnitt nach der Verdickung des Bolzens 45 wird mit 46 bezeichnet. Wenn die Hülse 41 über den Bolzen rutscht und die Verdickung sich an der Engstelle 43 aufbaut, relaxiert die Dehnung in der Hülse und die Verdickung zieht sich in das Befestigungsloch im Fahrzeugblech. Damit wird das Loch im Blech durch die Kombination aus Bolzen und Hülse sicher abgedichtet. Auch hier zeigen gleiche Bezugszeichen gleiche Elemente. Mit den Pfeilen ist die Kraftrichtung angedeutet.

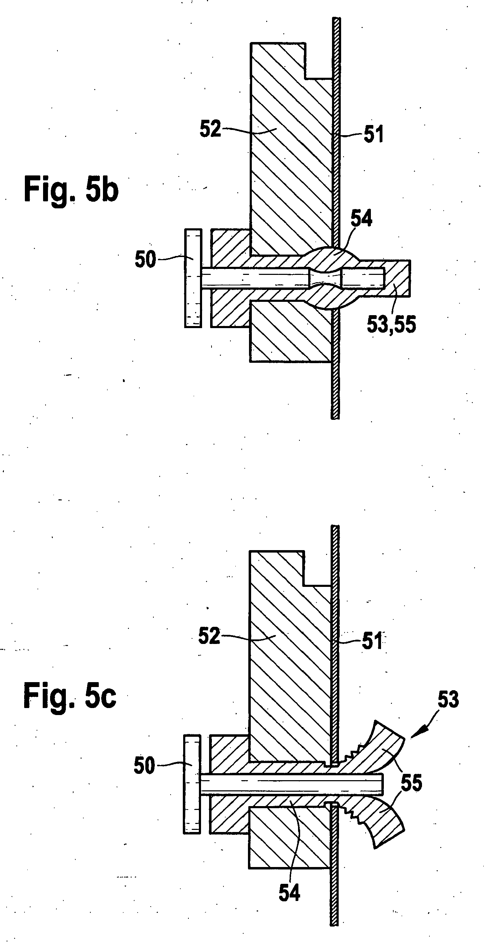

Figur 5a bis c zeigt verschiedene Auslegungsmöglichkeiten des erfindungsgemäßen Befestigungskonzepts. Gemäß Figur 5a wird der befestigte Zustand des Bolzens 50 mit der Hülse 53 in der Wand 51 gezeigt, wobei der Drucksensor 52 gekennzeichnet ist. Die Spitze 55 der Hülse und die Verdickung an der ehemaligen Engstelle 54 sind dargestellt. In Figur 5b ist zu sehen, dass die Verdickung 54 sich im Befestigungsloch befindet. Die Befestigung erfolgt dann im Wesentlichen durch Reibungskraft und weniger durch Zugkraft in der Hülse. Figur 5c zeigt die komplette Verspreizung der Hülse 53, was durch die Spreizelemente 55 dargestellt ist. Der Bolzen 50 hält damit den Unfallsensor 52 an der Wand 51.

## Patentansprüche

1. Unfallsensor (10) mit Befestigungsmitteln, die eine Befestigung des Unfallsensors an einer Wand in einem Fahrzeug ermöglichen, wobei die Wand eine erste Öffnung und eine zweite Öffnung aufweist und der Unfallsensor ein Luftdrucksensor (10) mit einem Druckkanal (12) ist, der durch die erste Öffnung der Wand (11, 51) eingeführt ist, und wobei der Unfallsensor wenigstens eine Bohrung aufweist, die einen Bolzen (15, 20, 30, 40, 50) in einer elastisch ausgebildeten Hülse (16, 24, 31, 41, 53) als Befestigungsmittel aufweist, wobei der Bolzen mit der Hülse so gestaltet ist, dass der Unfallsensor mit dem Bolzen mit der Hülse in der zweiten Öffnung der Wand durch eine Klemmung befestigt ist.

2. Unfallsensor nach Anspruch 1, **dadurch gekennzeichnet, dass** der Bolzen so gestaltet ist, dass der Bolzen beim Hineinschieben in die Hülse eine Aufweitung und/oder eine Verspreizung der Hülse verursacht, wobei die Aufweitung und/oder die Verspreizung die Klemmung bewirkt.

3. Unfallsensor nach Anspruch 1 oder 2, **dadurch gekennzeichnet, dass** der Bolzen wenigstens einen ersten Abschnitt für die Klemmung und einen nachfolgenden zweiten Abschnitt aufweist, der dünner als der erste Abschnitt ist.

4. Unfallsensor nach Anspruch 3, **dadurch gekennzeichnet, dass** der Bolzen wenigstens einen dritten Abschnitt aufweist, wobei der dritte Abschnitt wenigstens einen Widerhaken aufweist.

5. Unfallsensor nach Anspruch 3 oder 4, **dadurch gekennzeichnet, dass** der erste und der dritte Abschnitt weitgehend identisch sind.

6. Unfallsensor nach einem der vorhergehenden Ansprüche, **dadurch gekennzeichnet, dass** sich die Hülse beim Hineinschieben des Bolzens der Länge nach dehnt.

7. Unfallsensor nach einem der vorhergehenden Ansprüche, **dadurch gekennzeichnet, dass** die Hülse wenigstens eine Rippe und/oder wenigstens eine Rastnase aufweist.

8. Unfallsensor nach einem der vorhergehenden Ansprüche, **dadurch gekennzeichnet, dass** der Bolzen so gestaltet ist, dass der Bolzen beim Hineinschieben die Hülse durchbricht, sodass die Hülse verspreizt oder den Bolzen hintergreift.

9. Unfallsensor nach einem der vorhergehenden Ansprüche, **dadurch gekennzeichnet, dass** der Unfallsensor derart gestaltet ist, dass der Unfallsensor einen Stecker für einen Anschluss von Kabeln erst freigibt, wenn der Bolzen mit der Hülse in eine Endposition zur Befestigung des Unfallsensors geschoben ist.

## Claims

1. Accident sensor (10) with fastening means which enable the accident sensor to be fastened to a wall in a vehicle, the wall having a first orifice and a second orifice, and the accident sensor being an air pressure sensor (10) with a pressure duct (12) which is introduced through the first orifice of the wall (11, 51), and the accident sensor having at least one bore which has as fastening means a bolt (15, 20, 30, 40, 50) in an elastically designed sleeve (16, 24, 31, 41, 53), the bolt together with the sleeve being configured such that the accident sensor is fastened by means of the bolt together with the sleeve in the second orifice of the wall by clamping.

2. Accident sensor according to Claim 1, **characterized in that** the bolt is configured such that the bolt, when pushed into the sleeve, causes expansion and/or spreading of the sleeve, the expansion and/or spreading bringing about clamping.

3. Accident sensor according to Claim 1 or 2, **characterized in that** the bolt has at least one first portion for clamping and a following second portion which is thinner than the first portion.

4. Accident sensor according to Claim 3, **characterized in that** the bolt has at least one third portion, the third portion having at least one barb.

5. Accident sensor according to Claim 3 or 4, **characterized in that** the first and the third portion are largely identical.

6. Accident sensor according to one of the preceding claims, **characterized in that** the sleeve is extended in length when the bolt is pushed in.

7. Accident sensor according to one of the preceding claims, **characterized in that** the sleeve has at least one rib and/or at least one latching nose.

8. Accident sensor according to one of the preceding claims, **characterized in that** the bolt is configured such that the bolt, when pushed in, perforates the sleeve, so that the sleeve is spread or engages behind the bolt.

9. Accident sensor according to one of the preceding claims, **characterized in that** the accident sensor is configured in such a way that the accident sensor releases a plug for a connection of cables only when the bolt together with the sleeve is pushed into a final position for fastening the accident sensor.

## Revendications

1. Capteur d'accident (10) comprenant des moyens de fixation qui permettent une fixation du capteur d'accident à une paroi dans un véhicule, la paroi comprenant une première ouverture et une deuxième ouverture, et le capteur d'accident étant un capteur de pression d'air (10) comprenant un canal de pression (12) qui est inséré à travers la première ouverture de la paroi (11, 51), et le capteur d'accident comprenant au moins un alésage qui comprend, en tant que moyen de fixation, une cheville (15, 20, 30, 40, 50) dans une douille élastique (16, 24, 31, 41, 53), la cheville pourvue de la douille étant configurée de telle sorte que le capteur d'accident soit fixé par serrage dans la deuxième ouverture de la paroi à l'aide de la cheville pourvue de la douille.

2. Capteur d'accident selon la revendication 1, **caractérisé en ce que** la cheville est configurée de telle sorte que, lors de l'enfoncement dans la douille, la cheville provoque un élargissement et/ou une expansion de la douille, l'élargissement et/ou l'expansion produisant le serrage.

3. Capteur d'accident selon la revendication 1 ou 2, **caractérisé en ce que** la cheville comprend au moins une première portion pour le serrage et une deuxième portion suivante qui est plus mince que la première portion.

4. Capteur d'accident selon la revendication 3, **caractérisé en ce que** la cheville comprend au moins une troisième portion, la troisième portion comprenant au moins un crochet.

5. Capteur d'accident selon la revendication 3 ou 4, **caractérisé en ce que** la première et la troisième portion sont dans une large mesure identiques.

6. Capteur d'accident selon l'une quelconque des revendications précédentes, **caractérisé en ce que** la douille s'allonge dans le sens de la longueur lors de l'enfoncement de la cheville.

7. Capteur d'accident selon l'une quelconque des revendications précédentes, **caractérisé en ce que** la douille comprend au moins une nervure et/ou au moins un ergot d'encliquetage.

8. Capteur d'accident selon l'une quelconque des revendications précédentes, **caractérisé en ce que** la cheville est configurée de telle sorte que, lors de l'enfoncement, la cheville rompe la douille, de telle sorte que la douille présente une expansion ou vienne en prise par l'arrière avec la cheville.

9. Capteur d'accident selon l'une quelconque des revendications précédentes, **caractérisé en ce que** le capteur d'accident est configuré de telle sorte que le capteur d'accident ne libère un connecteur pour un raccordement de câbles que lorsque la cheville pourvue de la douille est poussée dans une position finale pour la fixation du capteur d'accident.
